Europäisches Patentamt

European Patent Office

Office européen des brevets

(11) Veröffentlichungsnummer: **0 269 758 B1**

# EUROPÄISCHE PATENTSCHRIFT

(45) Veröffentlichungstag der Patentschrift:
23.01.91 Patentblatt 91/04

(51) Int. Cl.⁵: **H03M 3/02, H03K 17/16**

(21) Anmeldenummer: **86116665.0**

(22) Anmeldetag: **01.12.86**

(54) **Stromumschalter.**

(43) Veröffentlichungstag der Anmeldung:
08.06.88 Patentblatt 88/23

(45) Bekanntmachung des Hinweises auf die
Patenterteilung:
23.01.91 Patentblatt 91/04

(84) Benannte Vertragsstaaten:
DE FR NL

(56) Entgegenhaltungen:
DE-A- 2 845 598
US-A- 4 527 133

(56) Entgegenhaltungen:
IEEE TRANSACTIONS ON INDUSTRIAL
ELECTRONICS AND CONTROL
INSTRUMENTATION, Band IECI-22, Nr. 3,
August 1975, Seiten 385-390, New York, US;
S.K. MULLICK et al.: "A nonlinear modulator
using delta modulation principles"
1974 IEEE INTERNATIONAL SOLID-STATE
CIRCUITS CONFERENCE, DIGEST OF
TECHNICAL PAPERS, Februar 1974, Seiten
192,193,247, IEEE, New York, US; G.L.
BALDWIN: "FAM 16.3: A linear delta
modulator/demodulator with 10 Mbit/S
sampling rate"

(73) Patentinhaber: Deutsche ITT Industries GmbH
Hans-Bunte-Strasse 19 Postfach 840
D-7800 Freiburg (DE)

(72) Erfinder: Theus, Ulrich, Dr.
Schönbergstrasse 5b
D-7803 Gundelfingen (DE)
Erfinder: O'Leary, Paul
Steurentalstrasse 3
D-7801 Stegen (DE)

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft einen Stromumschalter entsprechend und dem Oberbegriff des Anspruchs 1, wie er als Teilschaltung in US-A-4 527 133 und in dem Tagungsband, "1974 IEEE International Solid-State Circuits Conference Digest of Technical Papers", Feb. 1974, Seiten 192/193 beschrieben ist. Der Stromumschalter ist dabei Teil einer Digitalisierungs- bzw. Digital-Analogwandler-Schaltung, die nach dem "Delta-Modulationsverfahren" arbeitet. Bei der Dekodierung steuert z.B. der Logikpegel der Daten und das zugehörige Taktsignal den Schaltzustand dieses elektronischen Umschalters, dessen Ausgangssignal mittels eine Integrators und eines Tiefpaßfilters geglättet wird und damit das analoge Ausgangssignal ergibt.

Derartige Stromumschalter eignen sich z.B. auch zur Demodulation von pulsdauermodulierten Signalen, bei denen das tiefpaßgefilterte Ausgangssignal des Stromumschalters das demodulierte Ausgangssignal ist.

Ein Nachteil derartiger Demodulations-Schaltungen ist der Einfluß der an An- und Abstiegsflanken des Stromumschalter-Ausgangsstroms auf das analoge Ausgangssignal, das durch das über mehrere Taktperioden bestimmte Integral des umgeschalteten Stromes gebildet wird. Flankenverzerrungen, die sich im Integral nicht herausmitteln, führen so zu Störungen im Ausgangssignal und machen sich z.B. als Klirrfaktor oder Rauschen bemerkbar. Dieses nachteilige Verhalten wird z.B. in "Funk-Technik", 1975, Seiten 180 bis 184, insbesondere Kapitel 1.5.3, Seite 184, mit Bild 9 beschrieben. In US-A-4 527 133 wird ein eigener Regelkreis mit einem Hilfskondensator vorgeschlagen, um Abweichungen zwischen den beiden Konstantstromquellen auszugleichen.

Wenn bei der Demodulation eines Signals mit Pulsdichtemodulation der geforderte Signal-Rauschabstand von z.B. 85 dB für ein Audiosignal von 0-16 kHz erhalten bleiben soll, dann erfordert dies, daß bei einer Taktfrequenz von 5 MHz die dem Integralfehler entsprechende effektive Zeitabweichung pro An- oder Abstiegsflanke des umgeschalteten Stroms nicht größer als 100 ps sein darf. Zum Vergleich beträgt die entsprechende Aperturzeit eines gewichteten Digital-Analog-Wandlers mit 14 Bit Aussteuerbereich bei 85 dB Signal-Rauschabstand etwa 500 ps.

Es ist daher Aufgabe der in den Ansprüchen gekennzeichneten Erfindung, den beschriebenen Stromumschalter so weiterzubilden, daß der durch die Umschaltflanke bedingte Fehler im Stromintegral pro Schaltflanke höchstens einem effektiven Umschalt-Zeitfehler von ca 50 ps entsprechen darf, wenn der Verlauf der Schaltflanke zur zeitlichen Abschätzung selbst als ideal angenommen wird.

Ein wichtiger Vorteil der Erfindung besteht darin, daß die erforderliche Genauigkeit ohne das sonst übliche Return-to-Zero-Verfahren erreicht wird, bei dem die Taktfrequenz zu verdoppeln ist und bei dem unabhängig vom vorausgehenden Logikzustand die An- und Abstiegsflanken immer von einem Null-Bezugspegel oder von einem festen zusätzlichen Zwischenpegel aus beginnen. So eignet sich der erfindungsgemäße Stromumschalter bei Puls-Breite-, Puls-Dichte- und Delta-Modulationsschaltungen sowohl zur Hin- als auch zur Rückwandlung, ferner als Stromumschalter in Digital-Analogumsetzern mit hoher dynamischer Genauigkeit.

Ein weiterer Vorteil der Erfindung ist die Ausführbarkeit des Stromumschalters als monolithisch integrierte Schaltung, weil dadurch die parasitären Kapazitäten und Induktivitäten kleingehalten werden, was der Schaltgeschwindigkeit und der Schaltgenauigkeit zugute kommt.

Schließlich besteht ein Vorteil der Erfindung darin, daß in den Zuleitungen der Versorgungsspannungen nur konstanter Strom fließt und somit selbst bei hohen Taktfrequenzen auf den Versorgungsleitungen keine steilflankigen Impulse auftreten, die zu Störstrahlungen führen.

Die Erfindung wird nun anhand der Figuren der Zeichnung näher erläutert :

Fig. 1 zeigt eine schematische Darstellung des Stromumschalters mit angeschlossenem Tiefpaß,

Fig. 2 zeigt als Blockschaltbild ein Ausführungsbeispiel des Stromumschalters und

Fig. 3 zeigt ein Ausführungsbeispiel des Stromumschalters nach Fig. 2 in CMOS-Schaltungstechnik.

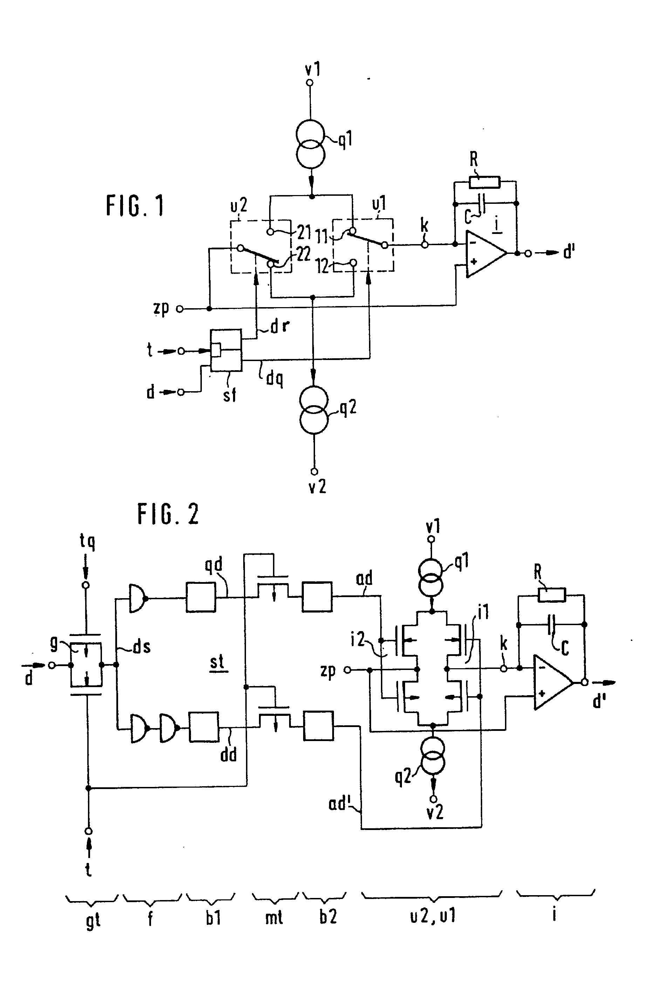

In Fig. 1 enthält der Stromumschalter den ersten und den zweiten elektronischen Umschalter u1, u2, deren erste bzw. zweite Eingänge 11, 21 ; 12, 22 zusammengeschaltet und an die Konstantstromquelle q1 bzw. Konstantstromsenke q2 angeschlossen sind. Der Fußpunkt der Konstantstromquelle q1 bzw. der Konstantstromsenke q2 ist mit der ersten bzw. mit der zweiten Versorgungsspannungsklemme v1, v2 verbunden.

Beim Ausgang des ersten und des zweiten elektronischen Umschalters u1, u2 ist einmal darauf zu achten, daß beide Anschlüsse zwecks guter Schaltungssymmetrie möglichst auf gleichem Potential liegen und zum anderen, daß der Spannungshub der beiden Ausgänge möglichst klein ist, damit die Hochohmigkeit der Konstantstromquelle q1 oder -senke q2 voll erhalten bleibt. Beides wird erreicht, indem die Ausgänge des ersten und des zweiten elektronischen Umschalters u1, u2 an das Bezugspotential zp indirekt oder direkt angeschlossen werden, wobei dessen Potential in der Mitte zwischen dem der ersten und der zweiten Versorgungsspannungsklemme v1, v2 liegt.

Der Ausgang des ersten elektronischen Umschalters u1 speist die Ausgangsklemme k, an die der invertierende Signaleingang des aktiven Tießpasses i angeschlossen ist. Da der nichtinvertierende Eingang am Bezugspotentialanschluß zp liegt, stellt der invertierende Eingang einen niederohmigen Anschluß mit dem Potential des Bezugspegels zp dar. Das RC-Glied des aktiven Tießpasses i liegt dabei in dessen Rückkopplungszweig.

Die Steuerung des ersten und des zweiten elektronischen Umschalters u1, u2 erfolgt derart, daß die beiden Schalter gegenphasig betrieben werden. Speist z.B. der erste elektronische Umschalter u1 die Ausgangsklemme k mit Strom aus der Konstantstromquelle q1, dann fließt aus dem Bezugspotentialanschluß zp der Strom über den zweiten elektronischen Umschalter u2 und über die Konstantstromsenke q2 zur zweiten Versorgungsspannungsklemme v2 ab. In der anderen Schalterstellung fließt der Strom aus der Konstantstromquelle q1 über den elektronischen Umschalter u2 zum Bezugspotential zp ab, während die Konstantstromsenke q2 über den ersten elektronischen Umschalter u1 ihren Strom aus der Ausgangsklemme k und damit aus dem Tiefpaß i zieht.

Die Steuerung der beiden elektronischen Umschalter u1, u2 erfolgt durch die Steuerschaltung sf, der das Digitalsignal als getaktetes Signal d zugeführt ist. Im einfachsten Fall ist die Steuerschaltung sf ein D-Flip-Flop, das mit der Taktfrequenz das am D-Eingang anliegende Signal – hier das getaktete Signal d – übernimmt und die beiden Flip-Flop-Ausgänge entsprechend umschaltet. Die Ausgangssignale der Steuerschaltung sf sind das zum getakteten Signal d phasengleiche Signal dr bzw. das dazu invertierte Signal dq.

Der Steuereingang des ersten elektronischen Umschalters u1 ist mit dem invertierten Signal dq gespeist. In der gezeichneten Schalterstellung ist dabei die Konstantstromquelle q1 mit der Ausgangsklemme k verbunden. Der Steuereingang des zweiten elektronischen Umschalters u2 ist mit dem zum getakteten Signal d phasengleichen Signal dr gespeist. In der gezeichneten Schalterstellung ist dabei sein Ausgangsanschluß mit der Konstantstromsenke q2 verbunden.

Der Steuerschaltung sf ist ferner das Taktsignal t zugeführt. Erst mit dem Eintreffen der Taktflanke des Taktsignals t erfolgt die gleichzeitige Umschaltung der beiden Ausgänge der Steuerschaltung sf entsprechend dem Logikpegel des getakteten Signals d. Durch diese Maßnahme ist der Umschaltzeitpunkt der elektronischen Umschalter u1, u2 unabhängig von gestörten Flanken des getakteten Signals d.

Eine ähnlich wirkende Schaltung wie im Ausführungsbeispiel nach Fig. 1 wird dadurch erreicht, daß die Konstantstromquelle q1 und die Konstantstromsenke q2 jeweils durch eine Spannungsquelle ersetzt sind und daß dafür in jede Ausgangsleitung der beiden elektronischen Umschalter u1, u2 zur Strombegrenzung jeweils ein Widerstand eingefügt wird, wobei beide Widerstände gleiche Werte haben.

In dem schematischen Ausführungsbeispiel nach Fig. 1 können die einzelnen Schaltfunktionen sowohl in Bipolar- als auch in MOS-Technik oder gar in einer kombinierten Technik ausgeführt sein. Bei sehr hohen Taktfrequenzen haben bekanntlich Bipolar-Transistoren Vorteile in der Schaltgeschwindigkeit gegenüber MOS-Transistoren, die indessen bei mittleren und niederen Frequenzen durch ihre leistungslose Schaltfunktion von Vorteil sind. Ein weiterer Gesichtspunkt ist dabei ein Vergleich der Symmetrie der elektrischen Eigenschaften, der für den jeweiligen Einsatz von Bipolar- oder MOS-Technik zu bedenken ist.

In dem teilweise als Blockschaltbild dargestellten Ausführungsbeispiel nach Fig. 2 sind die einzelne Funktionseinheiten eines erfindungsgemäßen Stromumschalters dargestellt, die teilweise in CMOS-Schaltungstechnik ausgeführt sind. Die Steuerstufe st enthält vom direktem und/oder invertierten Taktsignal t, tq gesteuerte Torschaltungen gt, mt, Inverter f und Hubbegrenzerschaltungen b1, b2. Der eigentliche Stromumschalter besteht aus zwei CMOS-Invertern i1, i2 die aber im Gegensatz zu normalen CMOS-Invertern über eine gemeinsame Konstantstromquelle q1 bzw. über eine gemeinsame Konstantstromsenke q2 mit der ersten bzw. zweiten Versorgungsspannungklemme v1, v2 verbunden sind.

Der Ausgang des ersten Inverters i1 ist über die Ausgangsklemme k mit dem aktiven Tießpaß i und der Ausgang des zweiten Inverters i2 ist mit einem Festpotentialanschluß, dem Bezugspotential zp, verbunden. Die Steuerschaltung st steuert mit ihren beiden gegenphasigen Ausgangssignalen ad', ad gegenphasig den ersten und zweiten Inverter i1, i2 an, so daß entweder der Strom der Konstantstromquelle q1 oder der der Konstantstromsenke q2 an die Ausgangsklemme k geschaltet wird. Die möglichst gute Symmetrie in der Erzeugung der beiden gegenphasigen Steuersignale ad', ad zusammen mit der Symmetrie des ersten und zweiten Inverters i1, i2 soll bewirken, daß insbesondere im Übergangsbereich die Stromübernahme vom ersten und zweiten Inverter i1, i2 ebenfalls einer symmetrischen Stromübernahme-Kennlinie folgt, wodurch der vorbeschriebene Integralfehler möglichst ausgeschaltet wird.

Diesem Zweck, nämlich der Symmetrierung der Stromübernahme-Kennlinie, dienen auch, anders als bei üblichen Inveransteuerungen, die beiden Hubbegrenzerschaltungen b1, b2 in den Steuerleitungen, die zwar den Schaltvorgang selbst etwas verlangsamen, dafür aber den gesamten Schaltvorgang definiert und gleichsam stationär anhand der ungestörten statischen Steuerkennlinie der Transistoren ablaufen lassen, weil dabei alle beteiligten Transistoren in ihrer Ausgangskennlinie hochohmig bleiben – MOS-Transistoren bleiben somit in Sättigung und Bipolar-Transistoren entsprechend im nichtgesättigten Aussteuerbereich, nämlich im Linearbereich.

Das vom invertierten Taktsignal tq geöffnete Eingangstor gt, im Ausführungsbeispiel das Transfergate g, hat in Verbindung mit dem zweiten Tor mt die Wirkungsweise eines Master-Slave-Flipflops, welches das getaktete Signal d abtastet. Das im Logikpegel stabile Signal ds speist die Interface-Schaltung f, die in erster Linie das zum stabilen Signal ds invertierte Signal qd und das entsprechende nichtinvertierte Signal dd erzeugt. Zugleich dient die Interface-Schaltung f der Impedanz- und der Logikpegelanpassung des zugeführten getakteten Signals d an die weitere Signalverarbeitung.

Die erste Hubbegrenzungschaltung b1 begrenzt den Hub der beiden getakteten Signale dd, qd nach der Interface-Schaltung f, damit bereits die nachfolgende zweite Hubbegrenzungs- und Pegelanpaßschaltung b2 ähnlich der vorbeschriebenen symmetrischen Übernahmekennlinie gleichsam statisch mit definierter gegenphasiger Steuerkennlinie angesteuert wird. Die zweite Hubbegrenzungs- und Pegelanpaßschaltung b2 bestimmt dann den genauen Arbeitspunkt und den genauen begrenzten Hub der beiden gegenphasigen Ansteuersignale ad', ad für den ersten und zweiten Inverter i1, i2, den eigentlichen Stromumschalter.

Die zeitliche Steuerung der jeweiligen Stromumschaltung bewirkt die vom Taktsignal t geöffnete zweite Torschaltung mt, die z.B. jeweils aus einem vom Taktsignal t gesteueerten n-Kanal-Transfertransistor besteht, der in den jeweiligen Signalpfad zwischen die erste und die zweite Hubbegrenzerschaltung b1, b2 eingefügt ist. Die zweite Torschaltung mt und die erste Hubbegrenzerschaltung b1 können auch in der Reihenfolge vertauscht werden.

Bei sehr hoher Datentaktfrequenz des getakteten Signals d kann auch in Fig. 2 der Übergang des gezeigten Ausführungsbeispiels auf reine ECL-Technik oder eine Kombination aus Bipolar- und MOS-Technik erforderlich sein.

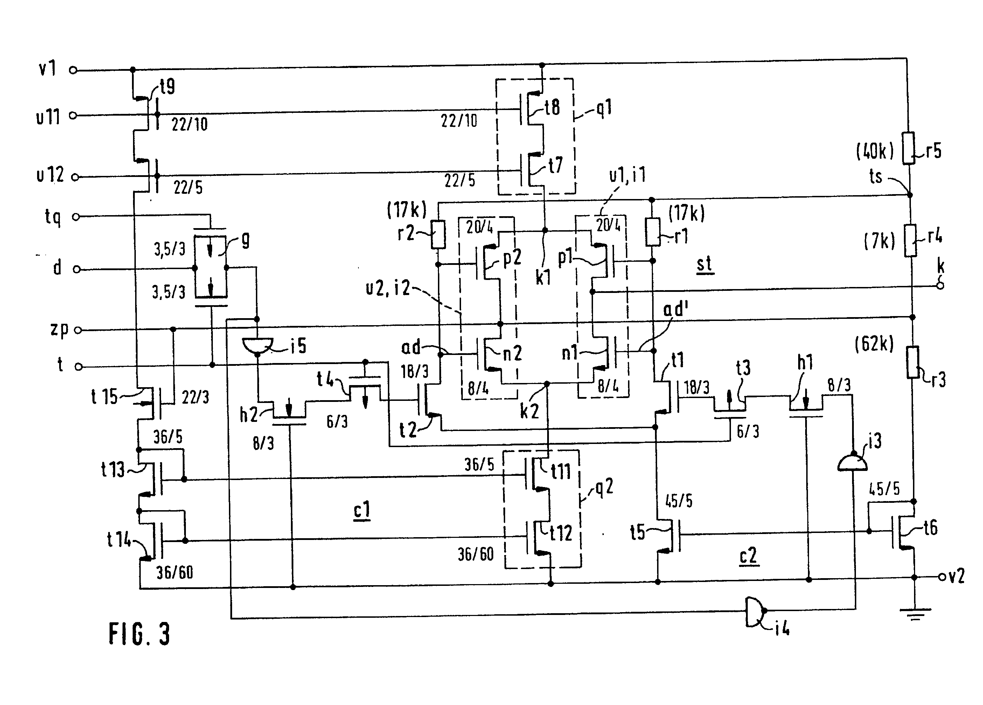

In dem CMOS-Ausführungsbeispiel des Stromumschalters nach Fig. 3 besteht der erste elektronische Umschalter u1 aus dem ersten Inverter i1 und der zweite elektronische Umschalter u2 aus dem zweiten Inverter i2. Der Source-Anschluß des ersten p-Invertertransistors p1 und der des zweiten p-Invertertransistors p2 liegen gemeinsam über die Konstantstromquelle q1 an der ersten Versorgungsspannungsklemme v1, die z.B. 8,5 V hat. Die Source-Anschlüsse des ersten und des zweiten n-Invertertransistors n1, n2 liegen gemeinsam über die Konstantstromsenke q2 an der zweiten Versorgungsspannungsklemme v2, deren Potential z.B. 0 V beträgt.

Somit entspricht der Source-Anschluß des ersten bzw. zweiten p-Invertertransistors p1, p2 dem ersten Eingang 11 ; 21 und der Source-Anschluß des ersten bzw. zweiten n-Invertertransistors n1, n2 dem zweiten Eingang 12 ; 22 des ersten bzw. zweiten elektronischen Umschalters u1, u2. Ferner entspricht der durch die beiden Gate-Anschlüsse des ersten bzw. zweiten Inverters i1, i2 gebildete Invertereingang dem Steuereingang des ersten bzw. zweiten elektronischen Umschalters u1, u2.

Der Ausgang des ersten Inverters i1 ist auf die Ausgangsklemme k geführt, und der Ausgang des zweiten Inverters i2 ist mit der Anschlußklemme für das Bezugspotential zp verbunden, das z.B. 4 V beträgt.

Der Invertereingang des ersten bzw. des zweiten Inverters i1, i2 liegt am Drain-Anschluß des ersten bzw. des zweiten n-Transistors t1, t2, die zusammen eine Differenzstufe bilden da deren beide Sourceanschlüsse miteinander verbunden sind. Der Gate-Anschluß des ersten bzw. des zweiten n-Transistors t1, t2 ist über den ersten bzw. zweiten n-Transfertransistor t3, t4, die jeweils einen vom Taktsignal t gesteuerten Längsschalter bilden, angesteuert. Der erste bzw. der zweite n-Transfertransistor t3, t4 ist seinerseits über den ersten bzw. zweiten p-Transfertransistor h1, h2 angesteuert. Der Gate-Anschluß der beiden p-Transfertransistoren h1, h2 ist mit der zweiten Versorgungsspannungsklemme v2 verbunden.

Durch diese beiden p-Transfertransistoren h1, h2 wird der Hub des jeweilig anstehenden Steuersignals reduziert von z.B. ca. 4 V auf 1 V. Dem Source-Anschluß des ersten p-Transfertransistors h1 ist das getaktete Signal d über die Reihenschaltung aus drittem und viertem Inverter i3, i4, und dem Source-Anschluß des zweiten p-Transfertransistors h2 ist es über den fünften Inverter i5 zugeführt. Damit wird erreicht, daß das Ausgangssignal ad' des ersten n-Transistors t1 dem invertierten Taktsignal dq und das Ausgangssignal ad des zweiten n-Transistors t2 dem getakteten Signal d entspricht. Da das getaktete Signal d z.B. über eine lange Leitung zugeführt und damit gestört sein kann, enthält der Steuerschaltungseingang für das getaktete Signal d das Transfergate g, das vom invertierten Taktsignal tq leitend geschaltet wird.

Die Lastwiderstände des ersten bzw. des zweiten n-Transistors t1, t2 der Differenzstufe sind der erste bzw. der zweite Lastwiderstand r1, r2 in den jeweiligen Drain-Zuleitungen, wobei die beiden drain-abgewandten Anschlüsse der beiden Lastwiderstände r1, r2 zusammengeschaltet und auf den Spannungsteileranschluß ts zwischen der ersten Versorgungsspannungsklemme v1 und dem Bezugspotentialanschluß zp geführt sind. Durch die Bemessung des aus dem vierten und fünften Widerstand r4, r5 gebildeten Spannungsteilers und den jeweiligen Wert des ersten und des zweiten Lastwiderstandes r1, r2 wird der Spannungshub an diesen beiden Widerständen bestimmt. Durch Begrenzung des Hubs auf z.B. 1 V werden die Transistoren der Konstantstromquelle oder -senke q1, q2 in Sättigung gehalten.

Die eben beschriebene Steuerschaltung st ist bezüglich des ersten und des zweiten Inverters i1, i2 elektrisch möglichst symmetrisch auszuführen, d.h., daß bei der Integration die Auslegung ebenfalls möglichst symmetrisch ist.

Ferner sind die Transistoren des ersten und zweiten Inverters i1, i2 so klein wie möglich zu dimensionieren, damit die durch die Gate-Umladung verursachten Schaltströme möglichst klein sind. Denn diese fließen unkontrolliert über die Inverterausgänge ab. Auch soll die Kanallänge der p- und n-Invertertransistoren p1, p2, n1, n2 dabei an die Anstiegs- und Abfallzeit des Schaltsignals am ersten und zweiten Lastwiderstand r1, r2 angepaßt sein. Die geringe Aussteuerung des komplementären Stromumschalters – der aus den beiden Invertern i1, i2 gebildet ist – ermöglicht zudem eine platzsparende direkte Verbindung der Gate-Anschlüsse der zugehörigen p- und n-Invertertransistoren p1, n1 ; p2, n2, weil die sonst üblicherweise verwendeten Bootstrap-Treiberstufen entfallen. Dies kommt ebenfalls der elektrischen Schaltungssymmetrie und damit dem Gleichverhalten zugute.

Die Konstantstromquelle q1 ist als Kaskodenschaltung ausgeführt und besteht aus der Serienschaltung des siebten und des achten p-Transistors t7, t8, wobei deren einer Anschlußpol, der Sourceanschluß des achten p-Transistors t8, mit der Versorungsspannungsklemme v1 und der andere Anschlußpol mit den Source-Anschlüssen des ersten und des zweiten p-Inverter-Transistors p1, p2 verbunden ist und so den ersten Verbindungsknoten k1 bildet.

Der Gate-Anschluß des achten p-Transistors t8 ist mit dem Gate-Anschluß des neunten p-Transistors t9 und mit der ersten Anschlußklemme u11 der ersten Vorspannungsquelle verbunden. Der Gate-Anschluß des siebten p-Transistors t7 ist mit dem Gate des zehnten p-Transistors t10 und mit der zweiten Anschlußklemme u12 der ersten Vorspannungsquelle verbunden. Der neunte bzw. der zehnte p-Transistor t9, t10, die beide als Kaskode in Serie geschaltet sind, ist identisch mit dem achten bzw. dem siebten p-Transistor t8, t7, wobei der Source-Anschluß des neunten p-Transistor t9 mit der ersten Versorgungsspannungsklemme v1 verbunden ist.

Das W/L-Verhältnis dieser vier p-Transistoren t7...t10 ist so vorgegeben, daß vom ersten Verbindungsknoten k1 aus gesehen die Konstantstromquelle q1 möglichst hochohmig wird. Dies wird einmal durch die Kaskodenschaltung aus siebtem und achtem p-Transistors t7, t8 erreicht und auch dadurch, daß das W/L-Verhältnis des siebten p-Transistors t7 größer als das des achten p-Transistors t8 ist. In Fig. 3 sind typische W/L-Verhältnisse neben den einzelnen Transistoren angegeben.

Die Konstantstromsenke q2 ist eine Kaskodenschaltung und wird durch die Serienschaltung von zwei n-Kanal-Transistoren gebildet, nämlich dem elften und zwölften n-Transistor t11, t12. Der Source-Anschluß des elften n-Transistors t11 ist auf den zweiten Verbindungsknoten k2 geführt, an dem auch die beiden Source-Anschlüsse des ersten und des zweiten n-Inverter-Transistors n1, n2 liegen. Der Source-Anschluß des zwölften n-Transistors t12 ist der Fußpunkt der Konstantstromsenke q2 und als solcher mit der zweiten Versorgungsspannungsklemme v2 verbunden.

Der Gate-Anschluß des elften n-Transistors t11 ist mit dem Gate-Anschluß des mit ihm gleichen 13. n-Transistors t13 und der Gate-Anschluß des zwölften n-Transistors t12 ist mit dem Gate-Anschluß des mit ihm gleichen 14. n-Transistors t14 verbunden. Die n-Transistoren t13, t14 sind als Kaskode so in Serie geschaltet, daß der Source-Anschluß des n-Transistors t14 mit der zweiten Spannungsversorgungsklemme v2 verbunden ist. Die Serienschaltung dieser beiden n-Kanal-Transistoren stellt zugleich die zweite Vorspannungsquelle für die Konstantstromsenke q2 dar, denn die beiden n-Transistoren t13, t14 sind als Dioden geschaltet, indem Drain und Gate miteinander verbunden sind. Da die entsprechenden Transistoren der Konstantstromsenke q2 und der beiden hintereinandergeschalteten Dioden untereinander gleich sind, bilden diese vier n-Transistoren t11...t14 die erste n-Stromspiegelschaltung c1. Ihr Eingang ist die Drain-Gate-Verbindung des n-Transistors t13, und ihr Ausgang ist der Drain-Anschluß des n-Transistors t11. Durch die Kaskodenschaltung der Transistoren mit der entsprechenden W/L-Dimensionierung wird die erste n-Stromspiegelschaltung c1 bezüglich ihres Ausgangswiderstandes sehr hochohmig.

Damit die Ströme der Konstantstromquelle q1 und der Konstantstromsenke q2 einander gleich sind, wird die erste n-Stromspiegelschaltung c1 mit einem Strom gespeist, der gleich dem Ausgangsstrom der Konstantstromquelle q1 ist. Dieser Strom ist der Strom aus der Serienschaltung der p-Transistoren t9, t10 und ist dem Eingang der ersten n-Stromspiegelschaltung c1 zugeführt. Umgekehrt ist auch die Ausführung der Konstantstromquelle q1 als p-Stromspiegelschaltung möglich, die dann mit einem Ausgangsstrom entsprechend dem Strom der Konstantstromsenke q2 gespeist wird.

Damit das Potential am Drainanschluß des p-Transistors t10 etwa gleich dem Potential des ersten Verbindungsknotens k1 ist, wird zwischen ihm und den n-Transistor t13 die Source-Drain-Strecke eines p-Kanal-Transistors, nämlich die des 15. p-Transistors t15 eingefügt, dessen Gate-Anschluß mit dem Bezugspotentialanschluß zp verbunden ist.

Mit dem Potential der ersten und der zweiten Anschlußklemme u11, u12 der ersten Vorspannungsquelle, die z.B. als eigene Referenzspannungsquellen auf dem Chip realisiert sind, kann der Strom der Konstantstromquelle q1 und damit auch der Strom der Konstantstromsenke q2 eingestellt werden.

Die Steuerstufe st enthält die zweite n-Stromspiegelschaltung c2. Sie ist in einfachster Form aus zwei miteinander gleichen n-Kanal-Transistoren aufgebaut. Der Ausgang ist der Drain-Anschluß des n-Transistors t5, der an die Verbindungsleitung zwischen den Source-Anschlüssen der n-Transistoren t1, t2 angeschlossen ist. Mit dem Gate des n-Transistors t5 ist das Gate des n-Transistors t6 und dessen Drain-Anschluß verbunden. Der Drain-Strom des n-Transistors t6 wird durch den Widerstand r3 bestimmt, dessen drain-abgewandter Anschluß mit dem Bezugspotentialanschluß zp verbunden ist.

## Ansprüche

1. Stromumschalter
   – mit einem ersten und einem zweiten elektronischen Umschalter (u1, u2), der synchron zu einem Taktsignal (t) vom jeweiligen Logikpegel eines getakteten Signals (d) gesteuert ist,
   – mit einer ersten und einer zweiten Stromquelle (q1, q2), die mit dem ersten bzw. zweiten elektronischen Umschalter verbunden ist,
   – mit einer Ausgangsklemme (k), die am Ausgang des elektronischem Umschalters angeschlossen ist, und
   – mit einer Steuerschaltung für den elektronischen Umschalter, der das getaktete Signal (d) und das Taktsignal (t) zugeführt sind, **gekennzeichnet durch folgende Merkmale** :
   – der erste bzw. zweite Eingang (11, 12) des ersten elektronischen Umschalters (u1) ist mit dem ersten bzw. zweiten Eingang (21, 22) des zweiten elektronischen Umschalters (u2) verbunden,
   – der Ausgang des zweiten elektronischen Umschalters (u2) liegt auf einem Bezugspotential (zp),
   – das Potential, an das die Ausgangsklemme (k) angeschlossen ist, ist etwa gleich dem Bezugspotential (zp),
   – die erste Stromquelle ist, auf die Ausgangsklemme (k) bezogen, eine Konstantstromquelle (q1) und die zweite Stromquelle eine Konstantstromsenke (q2), und
   – die Steuerschaltung (sf, st) steuert den zweiten elektronischen Umschalter (u2) gegenphasig zum ersten elektronischen Umschalter (u1).

2. Stromumschalter nach Anspruch 1 in CMOS-Technik, bei dem der erste bzw. zweite elektronische Umschalter (u1, u2) durch einen ersten bzw. zweiten Inverter (i1, i2) gebildet ist, wobei jeweils der Source-Anschluß des p-Invertertransistors (p1, p2) der erste Eingang (11, 21), der Source-Anschluß des n-Invertertransistor (n1, n2) der zweite Eingang (12, 22), der Inverterausgang der Ausgang und der Invertereingang der Steuereingang des elektronischen Umschalters (u1, u2) ist.

3. Stromumschalter in CMOS-Technik nach Anspruch 2, gekennzeichnet durch folgende Merkmale :
   – die Steuerschaltung (st) enthält eine Differenzstufe mit einem ersten und einem zweiten n-Transistor (t1, t2) an die ein erster bzw. zweiter Lastwiderstand (r1, r2) angeschlossen ist,
   – das Gate des ersten bzw. zweiten n-Transistors (t1, t2) ist jeweils über einen vom Taktsignal (t) gesteuerten ersten bzw. zweiten n-Transfertransistor (t3, t4) mit einem zum getakteten Signal (d) phasengleichen Signal (dr) bzw. einem dazu invertierten Signal (dq) gespeist, und
   – jeweils eines der beiden zueinander inversen Ausgangssignale (ad, ad') der Differenzstufe ist dem Invertereingang des ersten und des zweiten Inverters (i1, i2) zugeführt.

4. Stromumschalter nach Anspruch 1 in CMOS-Technik, bei dem die Konstantstromquelle (q1) mindestens einen p-Transistor enthält, dessen Gate mit einer ersten Vorspannungsquelle verbunden ist und daß die Konstantstromsenke (q2) mindestens einen n-Transistor enthält, dessen Gate mit einer zweiten Vorspannungsquelle verbunden ist.

5. Stromumschalter in CMOS-Technik nach Anspruch 4, dadurch gekennzeichnet, daß die erste Vorspannungsquelle und der p-Transistor der Konstantstromquelle (q1) Teile einer p-Stromspiegelschaltung sind und/oder daß die zweite Vorspannungsquelle und der n-Transistor der Konstantstromsenke (q2) Teile einer ersten n-Stromspiegelschaltung (c1) sind.

6. Stromumschalter nach Anspruch 1, gekennzeichnet durch folgende Merkmale :
   – die erste bzw. zweite Stromquelle ist durch eine erste bzw. zweite Spannungsquelle ersetzt,
   – zwischen den Ausgang des ersten elektronischen Umschalters (u1) und die Ausgangsklemme (k) ist ein erster Widerstand eingefügt,
   – zwischen den Ausgang des zweiten elektronischen Umschalters (u2) und die Anschlußklemme des Bezugspotentials (zp) ist ein zweiter Widerstand eingefügt, dessen Widerstandswert gleich dem des ersten ist, und
   – das Bezugspotential (zp) ist der Mittelwert des Potentials der ersten und der zweiten Spannungsquelle.

## Claims

1. Current switch comprising
- a first electronic switch (u1) and a second electronic switch (u2) controlled synchronously with a clock signal (t) by the respective logic level of a clocked signal (d),
- a first current source (q1) and a second current source (q2) connected to the first and second electronic switches, respectively,
- and output terminal (k) connected to the output of the electronic switch, and
- a control circuit for the electronic switch which is fed with the clocked signal (d) and the clock signal (t), characterized by the following features :
- The first input (11) and the second input (12) of the first electronic switch (u1) are connected to the first input (21) and the second input (22), respectively, of the second electronic switch (u2) ;
- the output of the second electronic switch (u2) is at a reference potential (zp) ;
- the potential connected to the output terminal (k) is approximately equal to the reference potential (zp) ;
- the first current source, referred to the output terminal (k), is a constant-current source (q1), and the second current source a constant-current sink (q2), and
- the control circuit (sf, st) controls the second electronic switch (u2) in phase opposition to the first electronic switch (u1).

2. A current switch as claimed in claim 1 and realized using CMOS technology wherein the first electronic switch (u1) and the second electronic switch (u2) are formed by a first inverter (i1) and a second inverter (i2), respectively, with the source terminal of a p-channel inverter transistor (p1, p2) being the first input (11, 21) of the respective electronic switch (u1, u2), the source terminal of an n-channel inverter transistor (n1, n2) being the second input (12, 22), the inverter output being the output, and the inverter input being the control input.

3. A current switch realized using CMOS technology as claimed in claim 2, characterized by the following features :
- The control circuit (st) contains a difference stage consisting of a first n-channel transistor (t1) with a first load resistor (r1) and a second n-channel transistor (t2) with a second load resistor (r2);
- the gate of the first n-channel transistor (t1) is fed with a signal in phase with the clocked signal (d) via a first n-channel transfer transistor (t3) controlled by the clock signal (t), and the gate of the second n-channel transistor (t2) is fed with a signal inverse to the inphase signal via a second n-channel transfer transistor (t4) controlled by the clock signal (t), and
- the two mutually inverse output signals (ad, ad')

of the difference stage are fed to the inputs of the first inverter (i1) and the second inverter (i2), respectively.

4. A current switch as claimed in claim 1 and realized using CMOS technology wherein the constant-current source (q1) contains at least one p-channel transistor having its gate connected to a first bias source, and that the constant-current sink (q2) contains at least one n-channel transistor having its gate connected to a second bias source.

5. A current switch as claimed in claim 4, characterized in that the first bias source and the p-channel transistor of the constant-current source (q1) form part of a p-channel current-mirror circuit, and/or that the second bias source and the n-channel transistor of the constant-current sink (q2) form part of a first n-channel current-mirror circuit (c1).

6. A current switch as claimed in claim 1, characterized by the following features :
- The first and second current sources are replaced by a first voltage source and a second voltage source, respectively ;
- a first resistor is connected between the output of the first electronic switch (u1) and the output terminal (k) ;
- a second resistor equal in value to the first resistor is connected between the output of the second electronic switch (u2) and the terminal for the reference potential (zp), and
- the reference potential is the mean value of the potentials of the first and second voltage sources.

## Revendications

1. Commutateur de courant comportant
- des premier et second commutateurs électroniques (u1, u2), qui sont commandés, en synchronisme avec un signal de cadence (t), par le niveau logique respectif d'un signal (d) commandé de façon cadencée,
- des première et seconde sources de courant (q1, q2), qui sont reliées aux premier et second commutateurs électroniques,
- une borne de sortie (k), qui est raccordée à la sortie du commutateur électronique,
- un circuit de commande pour le commutateur électronique, auquel sont envoyés le signal (d) commandé de façon cadencée et le signal de cadence (t), caractérisé par les caractéristiques suivantes :
- les première et seconde entrées (11, 12) du premier commutateur électronique (u1) sont reliées respectivement aux première et seconde entrées (21, 22) du second commutateur électronique (u2),
- la sortie du second commutateur électronique (u2) est raccordée à un potentiel de référence (zp),

– le potentiel, auquel est raccordée la borne de sortie (k), est approximativement égal au potentiel de référence (zp),

– la première source de courant est, rapportée à la borne de sortie (k), une source de courant constant (q1) et la seconde source de courant un puits de courant constant (q2), et

– le circuit de commande (sf,st) commande le second commutateur électronique (u2) en opposition de phase par rapport au premier commutateur électronique (u1).

2. Commutateur de courant selon la revendication 1, réalisé selon la technique CMOS, dans lequel les premier et second commutateurs électroniques (u1, u2) sont formés respectivement par des premier et second inverseurs (i1, i2), auquel cas respectivement la borne de source du transistor (p1, p2) de type p des inverseurs constitue la première entrée (11, 21), respectivement la borne de source du transistor (n1, n2) de type n des inverseurs forme la seconde entrée (12, 22) et la sortie des inverseurs constitue la sortie du commutateur électronique (u1, u2) et l'entrée de l'inverseur constitue l'entrée de commande de ce commutateur.

3. Commutateur de courant réalisé selon la technique CMOS selon la revendication 2, caractérisé par les caractéristiques suivantes :

– le circuit de commande (st) contient un étage différenciateur comportant des premier et second transistors (t1, t2) de type n, auxquels sont raccordées respectivement des première et seconde résistances de charge (r1, r2),

– la grille des premier et second transistors (t1, t2) de type n est alimentée respectivement par l'intermédiaire d'un premier ou second transistor de transfert (t3, t4) de type n, commandé par le signal de cadence (t), à un signal (dr) en phase avec le signal (d) commandé de façon cadencée ou un signal (dq) inverse du précédent, et

– respectivement l'un des deux signaux de sortie (ad,ad'), inverses l'un de l'autre, de l'étage différenciateur est envoyé à l'entrée des premier et second inverseurs (i1, i2).

4. Commutateur de courant selon la revendication 1, réalisé selon la technique CMOS, dans lequel la source de courant constant (q1) contient au moins un transistor de type p, dont la grille est raccordée à une première source de tension de polarisation, et le puits de courant constant (q2) contient au moins un transistor de type n, dont la grille est raccordée à une seconde source de tension de polarisation.

5. Commutateur de courant réalisé suivant la technique CMOS selon la revendication 4, caractérisé en ce que la première source de tension de polarisation et le transistor de type p de la source de courant constant (q1) font partie d'un circuit formant miroir de courant de type p et/ou que la seconde source de tension de polarisation et le transistor de type n du puits de courant constant (q2) font partie d'un premier circuit formant miroir de courant de type n (c1).

6. Commutateur de courant selon la revendication 1, caractérisé par les caractéristiques suivantes:

– les première et seconde sources de courant sont remplacées respectivement par des première et seconde sources de tension,

– une première résistance est insérée entre la sortie du premier commutateur électronique (u1) et la borne de sortie (k),

– entre la sortie du second commutateur électronique (u2) et la borne de raccordement du potentiel de référence (zp) est insérée une seconde résistance, dont la valeur résistive est égale à celle de la première résistance, et

– le potentiel de référence (zp) est la valeur moyenne des potentiels des première et seconde sources de tension.

FIG. 1

FIG. 2

FIG. 3